# EUROPEAN PATENT SPECIFICATION

(11) **EP 3 670 234 B1**
(45) Date of publication and mention of the grant of the patent: **24.11.2021**
(21) Application number: 18214103.6
(22) Date of filing: 19.12.2018
(51) Int. Cl.: B60K 35/00, B60K 37/06, G06F 3/0488, G06F 3/041, H03K 17/96

(54) **ARRANGEMENT OF AN OPERATING UNIT IN A MOTOR VEHICLE**
ANORDNUNG EINER BEDIENEINHEIT IN EINEM KRAFTFAHRZEUG
AGENCEMENT D'UNE UNITÉ DE FONCTIONNEMENT DANS UN VÉHICULE À MOTEUR

(43) Date of publication of application: 24.06.2020
(73) Proprietor: AUDI AG, 85045 Ingolstadt (DE); LG Electronics Inc., Seoul 150-721 (KR)
(72) Inventor: WALL, Christian, 85122 Hitzhofen (DE); HUFNAGEL, Anna, 81667 München (DE); KANG, Seung mo, Seocho-gu Seoul (KR); PARK, Sungjun, Seocho-gu Seoul (KR); OH, Jiwon, Gangseo-gu Seoul (KR)
(74) Representative: Hofstetter, Schurack & Partner

(56) References cited:
- DE-A1- 19 645 675
- DE-A1-102012 010 884
- US-A1- 2007 247 420
- US-A1- 2018 334 106

## Description

The invention relates to an arrangement of an operating unit in a motor vehicle according to the preamble of claim 1.

In modern motor vehicles, operating units with an operating panel, which is provided with an operating surface, e. g. a display, are being installed more frequently. The operating unit is usually designed with a touch-sensitive display via touch control. However, this requires accessibility of the display. Especially, in the piloted or automatic driving mode, when the driver assumes a comfort seat position, the accessibility of the operating panel is therefore not always easily guaranteed. For this reason, remote operating elements are provided as an alternative.

DE 196 45 675 A1 describes a switching unit that includes an electric motor, which is used to move a keypad with several pressure switches.

However, the disadvantage thereof is that these operating elements require a permanent space, do not always look attractive and furthermore cause extra costs.

It is therefore an object of the present invention to provide an arrangement of an operating unit in a motor vehicle, in which the operating panel can also be operated by the driver in a piloted driving mode if necessary.

According to the invention this object is achieved by the features mentioned in claim 1.

According to the invention, at least the operating panel of the operating unit can be mechanically brought into different height positions. For example, it can be folded down in the initial state and arranged flat in the vehicle. In this position, it is basically also operable. However, if, due to his seating position, the driver does not have sufficient visibility onto the control panel of the flat lying control panel of the control unit or it should not or only poorly be accessible, it can be folded up into an operating position such that it is visible and accessible to him for operating the operating area of the operating panel. The operating unit is arranged under a cover, for example a fabric-like material. For this purpose, the cover or the fabric-like material according to the invention is designed translucent or such that light can be guided through it. In this way, the operation panel arranged under the cover can be operated in a visible manner.

A very advantageous positioning of the operating unit may be in a center console located between the front seats.

If necessary, the operating unit can also be designed to be displaceable in the longitudinal direction of the vehicle, if this is advantageous for an easier operation.

In the following, an embodiment of the invention is described in principle with reference to the drawings.

In the figures:
Figure 1 shows an operating unit that does not form part of the present invention in a use position.
Figure 2 shows a control unit that does not form part of the present invention in the use position.
Figure 3 is a perspective view of an operating unit that does not form part of the present invention in the folded-up position.
Figures 4 - 6 are a schematic diagram of the control unit according to the invention in three positions with a conveyor belt as a closed system.

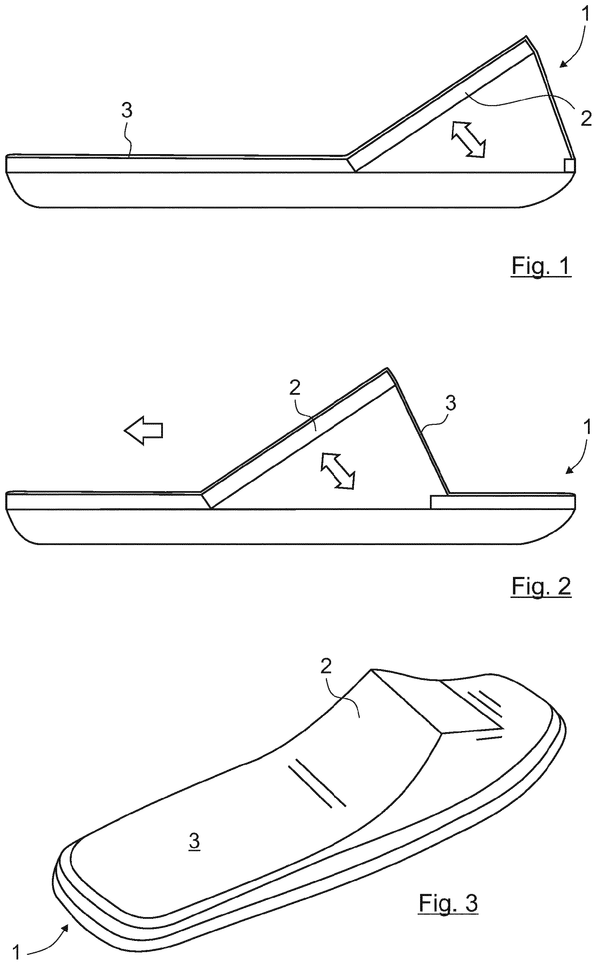

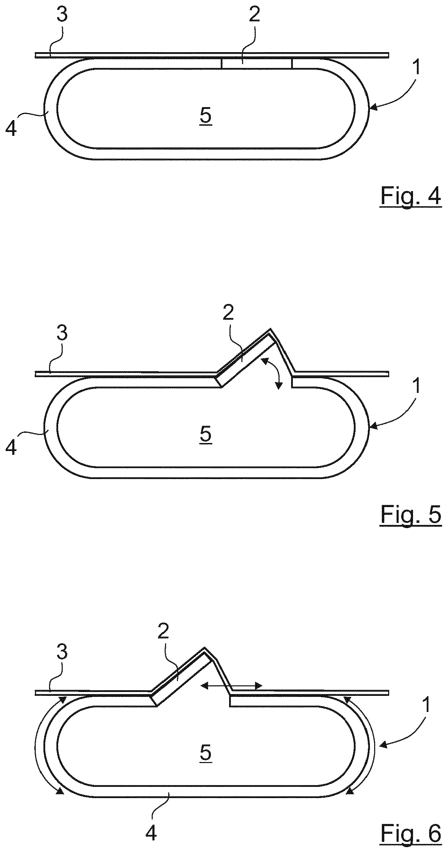

According to Figure 1, an operating unit 1 is provided in a known manner with a touch-sensitive operating panel 2, e. g. a display. The operating unit 1 with the display as the operating panel 2 is, for example, arranged in a center console 5 (see figures 4 - 6) between the front seats of the motor vehicle. The center console 5 has at least in the area of the operating unit 1 a cover 3 made of a translucent material or a material through which light can be guided, e. g. a fabric-like material, for which purpose also a plastic material can be used.

In a basic position (see figure 4), the operating panel 2 is in an at least approximately horizontal position. In the position shown in figure 1, the operating panel 2 is shown folded up from the horizontal position in the direction of the arrow. The positioning of the operating panel 2 in the folded-up position can be adjusted at any angle if necessary.

In order to enable the folded-up position of the operating panel 2, a cover should be used which is very elastic and does not form wrinkles.

Figure 2 shows an embodiment, in which the operating panel 2 is formed to allow an up-folding thereof centrally between the flat parts of the operating unit 1.

Figure 3 shows in a perspective view the operating unit 1 with the operating panel 2 folded up therefrom.

Even if the driver is in a comfort seating position, the operating surface of the operating panel 2 can thus be operated in a simple manner. In this case, it is generally also provided with an illuminating means, wherein the cover 3 should be designed to be translucent at least in the area of the control fields. The illuminating means for the operating panel 2 can for example also be provided by LED backlight.

In this way, the arrangement of the operating unit 1 in the center console 5 is ergonomically positioned, and it is not visible in the unused state due to the overlying cover 3. If necessary, the operating unit 1 can also be moved in the center console in the longitudinal direction against the direction of travel such that it can more easily be reached by the driver being in a comfort seating position.

Figures 4 to 6 show an embodiment as a closed system. There, the operating unit 1 is designed as a conveyor belt 4 or integrated into a conveyor belt 4. The conveyor belt 4 is arranged in the center console 5.

Figure 4 shows the operating unit 1 in the rest position or in the position with the operating panel 2 lying flat.

Figure 5 shows the operating panel 2 in the folded-up position, and figure 6 shows the position of the operating panel 2 having a displaced position facing the driver in the longitudinal direction of the vehicle. For this purpose, the conveyor belt 4 is actuated in accordance with the direction of the arrow.

The operating unit 1 can also be activated, for example, only after starting the vehicle. This means that in the non-activated situation it is invisible under the cover 3. Only after activation, the operating panel 2 of the operating unit 1 becomes visible under the transparent cover 3. Instead of a display with a correspondingly large operating surface, the operating panel 2 may be provided with only one or more simple LEDs, which are activated by the touch of a person accordingly, by means of which other units in the vehicle can then be controlled or activated.

## Claims

1. Motor vehicle comprising an operating unit (1) being arranged in said motor vehicle, wherein the operating unit (1) is located below an elastic cover (3) and the operation unit (1) is designed such that it can be folded up from an at least approximately horizontal position, **characterized in that**
the operating unit (1) comprises a touch-sensitive operating panel (2);
and **in that** the operating unit (1) is designed as a conveyor belt (4) or integrated into a conveyor belt (4) allowing the operating panel (2) to have a displaced position.

2. Motor vehicle according to claim 1,
**characterized in that**
the cover (3) is formed translucent in such a way that at least the operating areas of the operating panel (2) are visible.

3. Motor vehicle according to claim 1 or 2,
**characterized in that**
the cover (3) consists of a fabric-like material.

4. Motor vehicle according to one of claims 1 to 3,
**characterized in that**
the operating unit (1) is arranged in a center console (5) located between the front seats of the motor vehicle.

5. Motor vehicle according to one of claims 1 to 4,
**characterized in that**
the operating unit (1) is additionally designed to be displaceable in the longitudinal direction of the vehicle.

6. Motor vehicle according to one of claims 1 to 5,
**characterized in that**
the operating unit (1) is arranged as a closed system in a center console (5) of the motor vehicle.

## Patentansprüche

1. Kraftfahrzeug mit einer Bedienungseinheit (1), die in dem Kraftfahrzeug angeordnet ist, wobei sich die Bedienungseinheit (1) unterhalb einer elastischen Abdeckung (3) befindet und die Bedienungseinheit (1) derart gestaltet ist, dass sie von einer zumindest ungefähr horizontalen Position hochgeklappt werden kann,
**dadurch gekennzeichnet, dass**
die Bedienungseinheit (1) ein berührungsempfindliches Bedienungsfeld (2) umfasst;
und dass die Bedienungseinheit (1) als Transportband (4) gestaltet ist oder in ein Transportband (4) integriert ist, das ermöglicht, dass das Bedienungsfeld (2) eine verschobene Position aufweist.

2. Kraftfahrzeug nach Anspruch 1,
**dadurch gekennzeichnet, dass**
die Abdeckung (3) in einer solchen Weise lichtdurchlässig ausgebildet ist, dass zumindest die Bedienungsbereiche des Bedienungsfeldes (2) sichtbar sind.

3. Kraftfahrzeug nach Anspruch 1 oder 2,
**dadurch gekennzeichnet, dass**
die Abdeckung (3) aus einem gewebeartigen Material besteht.

4. Kraftfahrzeug nach einem der Ansprüche 1 bis 3,
**dadurch gekennzeichnet, dass**
die Bedienungseinheit (1) in einer Mittelkonsole (5) angeordnet ist, die sich zwischen den Vordersitzen des Kraftfahrzeugs befindet.

5. Kraftfahrzeug nach einem der Ansprüche 1 bis 4,
**dadurch gekennzeichnet, dass**
die Bedienungseinheit (1) zusätzlich so gestaltet ist, dass sie in der Längsrichtung des Fahrzeugs verschiebbar ist.

6. Kraftfahrzeug nach einem der Ansprüche 1 bis 5,
**dadurch gekennzeichnet, dass**
die Bedienungseinheit (1) als geschlossenes System in einer Mittelkonsole (5) des Kraftfahrzeugs angeordnet ist.

## Revendications

1. Véhicule à moteur comportant une unité de commande (1) étant agencée dans ledit véhicule à moteur, dans lequel l'unité de commande (1) est située sous un recouvrement élastique (3), et l'unité de commande (1) est conçue de manière à pouvoir être relevée à partir d'une position au moins approximativement horizontale,
**caractérisé en ce que**
l'unité de commande (1) comporte un panneau de commande sensible au toucher (2),
et **en ce que**
l'unité de commande (1) est conçue en tant que convoyeur à bande (4) ou intégrée dans un convoyeur à bande (4) permettant le panneau de commande (2) d'avoir une position déplacée.

2. Véhicule à moteur selon la revendication 1,
**caractérisé en ce que**
le recouvrement (3) est formé de manière translucide de telle sorte qu'au moins les zones de fonctionnement du panneau de commande (2) sont visibles.

3. Véhicule à moteur selon la revendication 1 ou 2,
**caractérisé en ce que**
le recouvrement (3) consiste en un matériau de type tissu.

4. Véhicule à moteur selon l'une quelconque des revendications 1 à 3,
**caractérisé en ce que**
l'unité de commande (1) est agencée dans une console centrale (5) située entre les sièges avant du véhicule à moteur.

5. Véhicule à moteur selon l'une quelconque des revendications 1 à 4, **caractérisé en ce que**
l'unité de commande (1) est conçue en outre pour être déplaçable dans la direction longitudinale du véhicule.

6. Véhicule à moteur selon l'une quelconque des revendications 1 à 5, **caractérisé en ce que**
l'unité de commande (1) est agencée en tant que système fermé dans une console centrale (5) du véhicule à moteur.
